(19) Europäisches Patentamt
European Patent Office
Office européen des brevets

(11) EP 2 257 136 B1

(12) EUROPEAN PATENT SPECIFICATION

(45) Date of publication and mention
of the grant of the patent:
**16.01.2019 Bulletin 2019/03**

(51) Int Cl.:
*H05H 1/24* (2006.01)    *B08B 7/00* (2006.01)
*H01J 37/32* (2006.01)   *H05H 1/48* (2006.01)

(21) Application number: **09711621.4**

(22) Date of filing: **20.02.2009**

(86) International application number:
**PCT/JP2009/052956**

(87) International publication number:
**WO 2009/104709 (27.08.2009 Gazette 2009/35)**

(54) **PLASMA GENERATOR**

PLASMAGENERATOR

GÉNÉRATEUR DE PLASMA

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(30) Priority: **22.02.2008 JP 2008042056**

(43) Date of publication of application:
**01.12.2010 Bulletin 2010/48**

(73) Proprietors:
• **NU Eco Engineering Co., Ltd.**
  **Aichi 470-0201 (JP)**
• **Fuji Machine Mfg. Co., Ltd.**
  **Chiryu-shi**
  **Aichi 472-8686 (JP)**

(72) Inventors:
• **HORI, Masaru**
  **Nagoya-shi**
  **Aichi 464-8601 (JP)**
• **KANO, Hiroyuki**
  **Nishikamo-gun**
  **Aichi 470-0201 (JP)**

• **AMANO, Kazuo**
  **Chiryu**
  **Aichi 472-8686 (JP)**
• **KOIKE, Tetsuya**
  **Chiryu**
  **Aichi 472-8686 (JP)**
• **YOSHIDA, Naofumi**
  **Chiryu**
  **Aichi 472-8686 (JP)**
• **IKEDO, Toshiyuki**
  **Chiryu**
  **Aichi 472-8686 (JP)**

(74) Representative: **TBK**
  **Bavariaring 4-6**
  **80336 München (DE)**

(56) References cited:
**WO-A2-2007/142166    JP-A- 7 286 274
JP-A- 2001 190 948    JP-A- 2003 027 210
JP-A- 2005 116 414    JP-A- 2005 336 659
JP-A- 2006 134 668    JP-A- 2006 277 953
JP-A- 2006 302 653    JP-A- 2008 010 373
JP-A- 2008 010 373**

**Description**

Technical Field

The present invention relates to a plasma generator and, more particularly, to a so-called atmospheric plasma generator.

Background Art

The present inventors previously developed atmospheric plasma generators and filed patent applications therefor (see Patent Documents 1 and 2). In the plasma generators, electrode surfaces facing each other are provided with microscale recesses, to thereby induce hollow cathode electric discharge, through which a plasma is generated. When a plasma-generating gas is caused to pass through the plasma-generating zone, a gas containing at least a plasma can be jetted. Through employment of such a plasma generator, high-density plasma can be readily generated under atmospheric pressure with a high-frequency voltage of about some kilovolts obtained from a single-phase commercial power source (100 V) by means of a voltage booster.

Patent Document 1: Japanese Patent Application Laid-Open *(kokai)* No. 2006-196210
Patent Document 2: Japanese Patent Application Laid-Open (kokai) No. 2006-272039

*Prior art* which is related to this field of technology can be found e.g. in document WO 2007/142166 A2 disclosing an atmospheric pressure plasma generating method, a plasma processing method and a component mounting method using the same, and a device using these methods, and in document JP 2008 010373 A disclosing an atmospheric pressure plasma generator.

Disclosure of the Invention

Problems to be Solved by the Invention

In generating plasma under atmospheric pressure, when a short inter-electrode distance is employed, electric discharge is unstable, whereas when the distance is 1 cm or longer, electric discharge cannot be maintained. Thus, according to Patent Documents 1 and 2, in the case where the plasma-generating zone is, for example, a longitudinally elongated zone, electrodes having a certain length and extending in the longitudinal direction are employed. However, when such long electrodes are provided to face each other, uniformity in density of the generated plasma is problematically impaired. Specifically, electric discharge start at spots on the electrode surfaces, and electric discharge cannot be uniformly generated in the relevant electrode surfaces. Due to unstable electric discharge, the plasma generators cannot be effectively employed for the plasma treatment of a considerable wide area of an object such as a surface portion of a liquid-crystal panel or the like. Furthermore, difficulty is encountered in increasing the volume of the plasma-generating zone. Therefore, limitations are imposed on the effective uses of the aforementioned plasma generators, although the plasma generators can generate high-density plasma under atmospheric pressure.

The present invention has been conceived in order to solve the aforementioned problem, and an object of the invention is to provide an atmospheric plasma generator having an elongated plasma-generating zone.

Means for Solving the Problems

In a first aspect of the present invention, there is provided an atmospheric plasma generator according to claim 1. Further details are set out in the dependent claims.

The present invention is directed to an apparatus for generating linear plasma under atmospheric pressure and for irradiating an object to be treated (hereinafter may be referred to as treatment object) with the linearly extended plasma. The holes of the gas discharge section may be provided in a line or a plurality of lines along the longitudinal direction. The diameter of each hole at the base (i.e., the end connecting to the plasma-generating zone) may be different from that at the tip, and the diameter at the tip may be smaller than that at the base. Alternatively, the diameter at the tip may be larger than that at the base. The hole may be tapered, or the diameter of the hole may be varied stepwise. When the apparatus of the invention is employed with the tip of each hole being apart from the treatment object, no electric discharge occurs between the gas discharge section and the treatment object, even though the length of the hole is shortened. In this case, the treatment effect is weak. However, through increasing the amount of gas flow, a satisfactory treatment effect can be attained, even when the tips are apart from the treatment object.

**The** gas intake section **may have** a diffusion section for supplying the plasma-generating gas over the plasma-generating zone uniformly in the longitudinal direction, the diffusion section having a number of guide portions for guiding the plasma-generating gas in a direction normal to the longitudinal direction of the plasma-generating zone. Through this configuration, a plasma-generating gas can be supplied over the plasma-generating zone uniformly in the longitudinal direction. These guide portions may be formed as a grid-like pattern or formed of a plurality of walls of the holes.

**Said** holes of the gas discharge section **may** have such a length that no electric discharge occurs with respect to an object to be irradiated with plasma. Through this configuration, the object is not damaged. In consideration of deactivation of radicals, the length of the hole is most preferably the shortest length, so long as no such discharge occurs.

**Said** holes of the gas discharge section **may** have a tip having a diameter of 0.1 mm to 1 mm. Through this configuration, a treatment object can be irradiated selectively with only radicals among the plasma particles. That is, electrons are absorbed by the walls of the holes.

**Said** holes of the gas discharge section **may** have a length which is 1/2 times or more the distance between said pair of electrodes. In this case, electric discharge with respect to a treatment object can be prevented.

**Said** holes of the gas discharge section **may** have an oblique portion which is oblique with respect to a direction normal to the longitudinal direction. Through this configuration, electrons can be efficiently absorbed by the inner walls of the oblique holes, whereby a treatment object can be irradiated with radicals of higher purity. In addition, irradiation of the treatment object with UV rays, vacuum UV rays, visible light, etc. can be prevented. UV rays emitted in the plasma-generating zone are intercepted by the inner walls of the oblique holes. Thus, irradiation of the treatment object with UV rays, which would otherwise be emitted through the tips of the holes, can be prevented. Therefore, damage of the treatment object, which would otherwise be caused by the light (e.g., UV light) emitted in the plasma-generating zone, can be prevented.

**Said** pair of electrodes **may be** disposed with a spacing of 1 cm to 50 cm.

**At** least one electrode of said pair of electrodes **may be** provided with hollow portions on a surface thereof which face the other electrode.

**The** longitudinal length L (cm) of the columnar plasma-generating zone and the cross-sectional area $\sigma$ (mm$^2$) normal to the longitudinal direction **may** satisfy the following relationships:

$$2 \leq L\sigma \leq 200 \text{ and } 3 \leq \sigma \leq 25.$$

When the conditions are satisfied, plasma can be effectively generated. More preferred conditions are $2 \leq L\sigma \leq 100$ and $3 \leq \sigma \leq 25$.

**Said** holes of the gas discharge section **may** have a cross-section normal to a direction of gas flow, the cross-section being at least one selected from a group consisting of a circle, an oval, and a rectangle or a slit-like pattern having a longer side normal to the line of arrangement of the holes.

Effects of the Invention

In the present invention, an atmospheric plasma is generated in the space defined (or surrounded) by the casing made of an insulator. In the columnar space defined (or surrounded) by the insulator casing, an elongated plasma zone is realized. In the present invention, a conceivable role of the insulator is such that the inner surfaces of the casing

directed to a specific embodiment of any of the first to seventh aspects, at least one electrode of said pair of electrodes is provided with hollow portions on a surface thereof which face the other electrode.

In a ninth aspect of the present invention, which is directed to a specific embodiment of any of the first to seventh aspects, the longitudinal length L (cm) of the columnar plasma-generating zone and the cross-sectional area $\sigma$ (mm$^2$) normal to the longitudinal direction satisfy the following relationships:

$$2 \leq L\sigma \leq 200 \text{ and } 3 \leq \sigma \leq 25.$$

When the conditions are satisfied, plasma can be effectively generated. More preferred conditions are $2 \leq L\sigma \leq 100$ and $3 \leq \sigma \leq 25$.

In a tenth aspect of the present invention, said holes of the gas discharge section have a cross-section normal to a direction of gas flow, the cross-section being at least one selected from a group consisting of a circle, an oval, and a rectangle or a slit-like pattern having a longer side normal to the line of arrangement of the holes.

Effects of the Invention

In the present invention, an atmospheric plasma is generated in the space defined (or surrounded) by the casing made of an insulator. In the columnar space defined (or surrounded) by the insulator casing, an elongated plasma zone is realized. In the present invention, a conceivable role of the insulator is such that the inner surfaces of the casing are electrically charged, to thereby stabilize plasma generation occurring in the entire plasma-generating zone extending in the longitudinal direction and having a large volume.

The plasma-generating gas is supplied through the gas intake section to the plasma-generating zone in a direction normal to the longitudinal direction of the zone, and discharged through a number of holes included in the gas discharge section. In this manner of gas flow, radicals are generated at a uniform density over the zone along the longitudinal direction thereof, and a treatment object is irradiated with the thus-generated radicals which are jetted straight through the tips of the holes. Through employment of hollow cathode electric discharge provided by means of electrodes having a recessed surface disclosed in Patent Document 1 or 2, plasma can be readily generated under atmospheric pressure. When the holes of the gas discharge section have a length which is 1/2 times or more the distance between said pair of electrodes, electric discharge with respect to a plasma treatment object is prevented. The hole length is most preferably 1/2 times the distance between said pair of electrodes. When the length is longer than the 1/2 length; that is, when the length from the plasma-generating zone to the treatment object is long, the generated radicals are deactivated, which is not preferred. In the case where the inter-electrode distance is 40 mm, the most preferred hole length has been found to be 20 mm. The columnar plasma-generating zone of the invention has a longitudinal length L (cm) of 1 to 50, and a cross-sectional area $\sigma$ (mm$^2$) normal to the longitudinal direction is 3 to 25. In the columnar plasma-generating zone, the smaller the cross-sectional area $\sigma$, the longer the length L. The length L can be increased, when the casing is substantially tubular. Some experiments have revealed that stable plasma can be formed under the relationship: $2 \leq L\sigma \leq 200$. For more effective generation of plasma, the following relationships: $2 \leq L\sigma \leq 100$ and $3 \leq \sigma \leq 25$, are satisfied.

Brief description of the Drawings

[FIG. 1] A cross-section of the structure of an embodiment of the plasma generator according to the present invention.
[FIG. 2] A cross-section of a part of the embodiment of the plasma generator.
[FIG. 3] A cross-section of the electrode configuration of the embodiment of the plasma generator.
[FIG. 4] A cross-section of the structure of another specific embodiment of the plasma generator according to the present invention.

Best Modes for Carrying Out the Invention

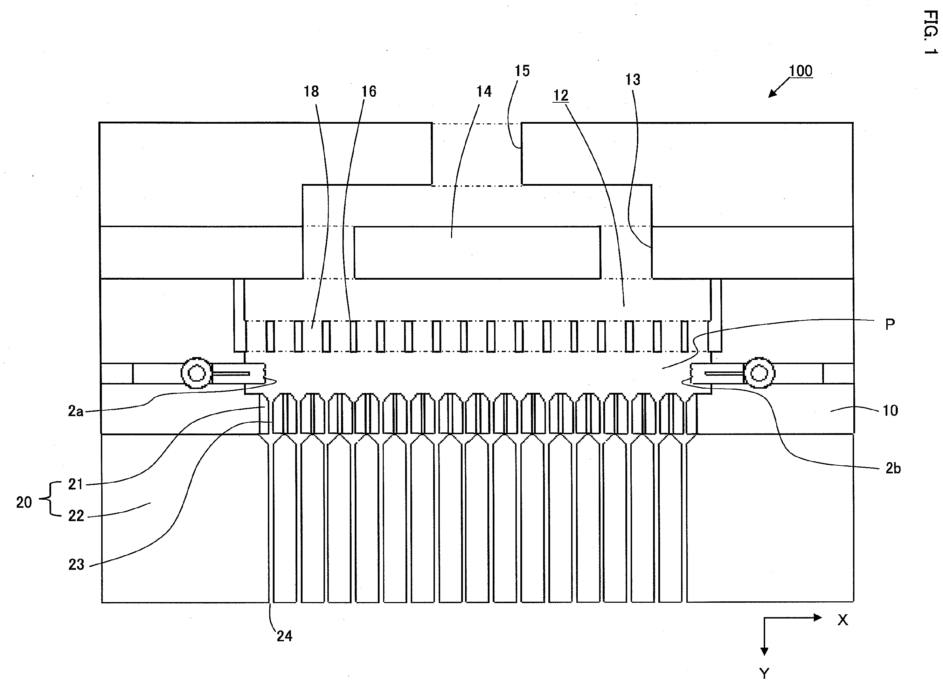

The casing must be made from a material which has high resistance to plasma generated in the inside thereof. For example, a ceramic material such as sintered boron nitride (PBN) is preferred. The electrodes may be formed from stainless steel, molybdenum, tantalum, nickel, copper, tungsten, platinum, or an alloy thereof. The electrode surface in which hollow portions for providing hollow cathode electric discharge are provided preferably has a thickness (in the Y-axis direction in FIG. 1; i.e., the gas flow direction) of about 1 to about 5 mm. When the surface has a sufficient thickness, hollow portions can be formed to have different depths along the gas flow direction, to thereby enhance gas flow rate and density of the generated plasma. The electrode surfaces facing each other preferably have a rectangular shape, which is similar to a cross-section of the plasma-generating zone normal to the longitudinal direction. A hollow portion for providing hollow cathode electric discharge preferably has a depth of, for example, about 0.5 mm. The hollow portions may be formed non-continuously (i.e., dot-like) or continuously (i.e., groove-like, extending along the perpendicular direction in FIG. 1). However, continuous hollow portions are preferred. When the hollow portions are formed in a dot-like manner, the electrodes may have a cross-section normal to the inter-electrode direction (i.e., x-axis direction in FIG. 1) which cross-section has a shape of, for example, columnar, semi-spherical, prismatic, pyramidal, etc.

Examples of the gas which may be used at atmospheric pressure for generating plasma include air, oxygen, rare gas (He, Ne, Ar, etc.), nitrogen, and hydrogen. By use of air or oxygen, active oxygen radicals are formed, and organic contaminants can be effectively removed. Use of air is advantageous in view of economy. In the case where Ar gas (rare gas) is used, oxygen radicals are generated from oxygen molecules existing in an atmosphere around a treatment object by the Ar plasma during irradiation of a treatment object with the Ar plasma. By the mediation of oxygen radicals, organic contaminants present on the surface of the treatment object can be effectively removed. This process is economical because a sole gas of Ar is used. For the aforementioned reasons, a mixture of air and Ar may also be used. The flow rate and supply amount of the gas and the degree of vacuum may be selected as desired. In the present invention, plasma is not generated by high-frequency voltage. The power source connected to each electrode may be a DC power source, an AC power source, a pulse power source, or another power source, and no particular limitation is imposed on the frequency.

When a plasma gas is jetted through the outlets (i.e., a number of holes included in the gas discharge section) to a treatment object, the distance between each jetting outlet and the treatment object, which depends on the gas flow rate, is preferably, for example, 2 mm to 20 mm, more preferably 3 mm to 12 mm, most preferably 4 mm to 8 mm. When oxygen radicals are generated, the distance is preferably adjusted so that, on the surface of the treatment object, the oxygen radical density is maximized and the electron density is minimized. Through employment of the above conditions, charge-up damage of the treatment object can be prevented, and the treatment object can be cleaned in the most effective manner. Alternatively, the treatment object may be irradiated with plasma in a direction slanted from the gas flow direction. Through plasma irradiation in this manner, impairment of products caused by irradiation of plasma to a polarized film, a liquid crystal-sealant, etc. can be prevented. Onto an area where plasma irradiation should be avoided, a gas such as plasma-free air may be sprayed, so as to prevent diffusion of plasma.

Oxidation of the electrodes is preferably prevented through lowering the oxygen concentration by use of a gas containing nitrogen, Ar, or hydrogen (reducing gas). Alternatively, a plurality of plasmas may be generated so as to remove organic contaminants and prevent reaction with the remaining area. Also, a gas generated from the portion of the treatment object irradiated with plasma after reaction is preferably removed via suction. Through removal of the gas, deposition of the molecules which have been reacted with organic contaminants on remaining areas of the treatment object can be prevented. The temperature and density of the plasma, which are measured through, for example, laser beam absorption spectrometry, are preferably adjusted to predetermined levels by feed-back-controlling of applied voltage, duty ratio (in the case of pulse voltage application), irradiation time, gas flow rate, etc.

Through performing control in the aforementioned manner, high-quality cleaning and shortened cleaning time can be realized. In the case where a plurality of outlets of the holes are disposed in a line, irradiation with plasma can be limited only to a required portion of the treatment object by appropriately adjusting the diameters and lengths of the holes. Also preferred is cooling of the plasma-generating gas supplied to the plasma generator of the invention. Through cooling, elevation of the plasma temperature to a level higher than the required level can be prevented, and impairment of products such as liquid crystal displays; e.g., damage to polarized film, can be prevented. According to the present invention, a very small-scale plasma generator can be realized. Thus, in one possible mode, a plurality of plasma jetting holes are provided in the gas discharge section, and irradiation with high-density plasma can be confined to an anisotropic conductive film (ACF)-attached substrate portion. Also, the present cleaning device can be effectively installed in a very narrow space of a liquid crystal display fabrication apparatus. A hole of the gas discharge section may have an oblique angle with respect to the imaginary line which is normal to the longitudinal direction of the plasma-generating zone, and the oblique direction may be any direction within 360° along the imaginary line.

Throughout the above-described aspects of the invention, plasma generation is performed under atmospheric pressure. However, in an example not forming part of the invention, reduced or increased pressure may be employed. The term "atmospheric pressure" herein encompasses about 0.5 to about 2 atm. The holes of the gas discharge section may have a tip diameter of 0.1 mm to 1 mm. When the hole diameter is shorter, the gas flow rate increases. In this case, the treatment object is irradiated at high possibility with plasma without deactivation of radicals, which is preferred, and suitable radical irradiation can be realized. When the holes of the gas discharge section have a length which is 1/2 times or more the distance between said pair of electrodes, electric discharge with respect to a treatment object can be effectively prevented.

Embodiment 1

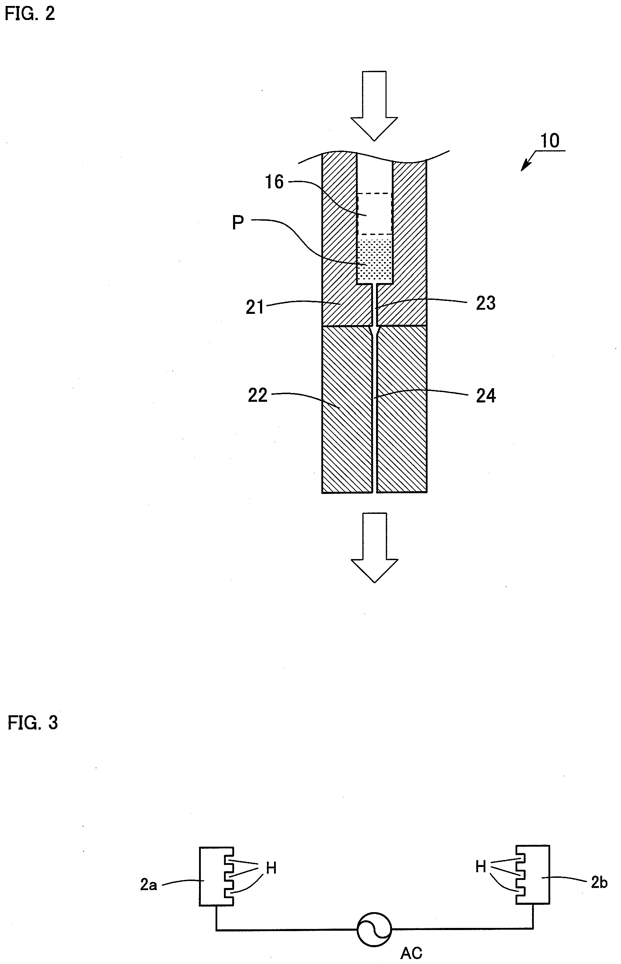

FIG. 1 is a cross-section of the configuration of a plasma generator 100, which is a specific embodiment of the present invention. FIG. 2 is a cross-section (partial view) of the plasma generator 100 shown in FIG. 1, cut along a direction normal to the longitudinal direction of a plasma-generating zone P.

The plasma generator 100 shown in FIG. 1 has a casing 10 made of a sintered ceramic produced from alumina ($Al_2O_3$) as a raw material. In the casing 10, there is disposed the plasma-generating zone P extending along the longitudinal direction (hereinafter referred to as a "x-axis direction"). The casing 10 has a gas intake section 12 including a hole 15 having a diameter of 8 mm, two holes 13 having a diameter of 5 mm, a diffusion plate 14 provided with the holes 13, and a guide portion 16. Each hole 13 may have a rectangular shape having a longer side along the x-axis, or a slit-like shape. A gas is supplied through the hole 15 and divided into two flows in the x-axis direction by means of the diffusion plate 14. The two gas flows are transferred through the holes 13 and guided to the plasma-generating zone P. The guide portion 16 has a number of holes having a diameter of 1.5 mm which are provided for allowing the gas to flow in a direction normal to the x-axis direction (hereinafter this gas flow direction is referred to as a "Y-axis direction) so as to attain a uniform gas distribution, in the x-axis direction, over the plasma-generating zone P. The guide portion 16 is provided with a plurality of holes disposed therein as a grid-like pattern and defined by corresponding wall surfaces. The holes and the wall surfaces form a diffusion section 18. On the downstream side of the plasma-generating zone P, there is provided a gas discharge section 20 which is formed of a first gas discharge section 21 and a second gas discharge section 22. The first gas discharge section 21 is provided with a number of holes 23 which extend along the y-axis direction and which are disposed along the x-axis direction. The second gas discharge section 22 is provided with a number of holes 24 which extend along the y-axis direction and which are disposed along the x-axis direction. The holes 23 and 24 have a diameter of 0.5 mm. The holes 23 have a length of 4 mm, and the holes 24 have a length of 16 mm. The holes 23 and 24 have x-axis intervals of 2.5 mm, and are provided in a number of 16 holes 23 and 16 holes 24.

The plasma-generating zone P has a rectangular cross-section (short side: 2 mm, long side 5 mm) in a direction normal to the x-axis direction. The long side is along the y-axis direction. The x-axis length of the zone P is 4 cm. As shown in FIG. 3, electrodes 2a, 2b each have a rectangular cross-section in a direction parallel to the gas flow in FIG. 1 (i.e., a cross-section parallel to the y-axis in FIG. 1). The electrodes 2a, 2b each have a rectangular cross-section in a direction normal to the x-axis direction, the cross-section being similar to the cross-section of the plasma-generating zone P in a direction normal to the x-axis direction. As shown in FIG. 3, the electrodes 2a, 2b have a roughened surfaces which are provided with numerous hollow portions H having a depth of about 0.5 mm on the surfaces thereof facing each other. The power sources employed in Embodiment 1 supply about 9 kV, which is obtained by boosting a commercial AC voltage of 100 V (60 Hz), and a voltage of 9 kV is applied to the electrodes 2a, 2b. The current flowing between the electrodes 2a and 2b is 20 mA. When argon gas is supplied through the gas intake section 12, a plasma was generated, even when the electrodes 2a, 2b were separated at a maximum spacing of 4 cm along the x-axis direction.

The plasma generator 110 can enhance adhesion between the glass substrate of a liquid-crystal display and anisotropic conductive film (ACF), in the case where an area of the glass substrate to which ACF is attached is cleaned by the plasma generator before attachment of ACF to the substrate.

Then, through varying the length of the side of the cross-section normal to the x-axis direction of the plasma-generating zone P while the distance (along the x-axis) between the electrodes 2a and 2b was fixed to 4 cm, stable electric discharge was generated when the side length was 5 mm or less. When the distance between the electrodes 2a and 2b was varied while the length of the side of the cross-section of the plasma-generating zone P was fixed to 5 mm, stable linear electric discharge was generated when the distance was 4 cm or shorter.

Subsequently, through employment of the above apparatus, the surface of a glass substrate of a liquid-crystal display was hydrophilicized with argon gas plasma. The contact angle of the surface before the treatment was 50°, but was reduced to 7° after the treatment. When the same apparatus as shown in FIG. 1, except that no second gas discharge section 22 was provided, was employed, electric discharge was observed between the glass substrate and the tips of the holes 23. In contrast, when the apparatus of Embodiment 1 shown in FIG. 1 was employed, no such electric discharge was observed. Therefore, the apparatus allows plasma treatment of a treatment object without damaging the object. Separately, oxygen radical concentration was measured when the same apparatus as shown in FIG. 1, except that no second gas discharge section 22 was provided, or the apparatus shown in FIG. 1 having the second gas discharge section 22 was employed. Specifically, a plasma-generating gas containing oxygen and argon was supplied to each apparatus, and the oxygen radical concentration was measured at a point 5 mm from the tips of the holes. The oxygen content was varied from 0% to 4%. The oxygen radical density was measured by vacuum UV absorption spectrometry. When the second gas discharge section 22 was provided, the oxygen radical density was found to be $3\times10^{14}/cm^3$ to $7\times10^{14}/cm^3$. When the apparatus having no second gas discharge section 22 was employed, the oxygen radical density was found to be $3\times10^{14}/cm^3$ to $2.4\times10^{15}/cm^3$. Therefore, provision of the second gas discharge section 22 does not considerably impair the effect of hydrophilicization. The electron density in the plasma-generating zone P was found to be $2\times10^{16}/cm^3$, when the oxygen content was 3% and the gas flow rate was 3 Liter/min.

Embodiment 2

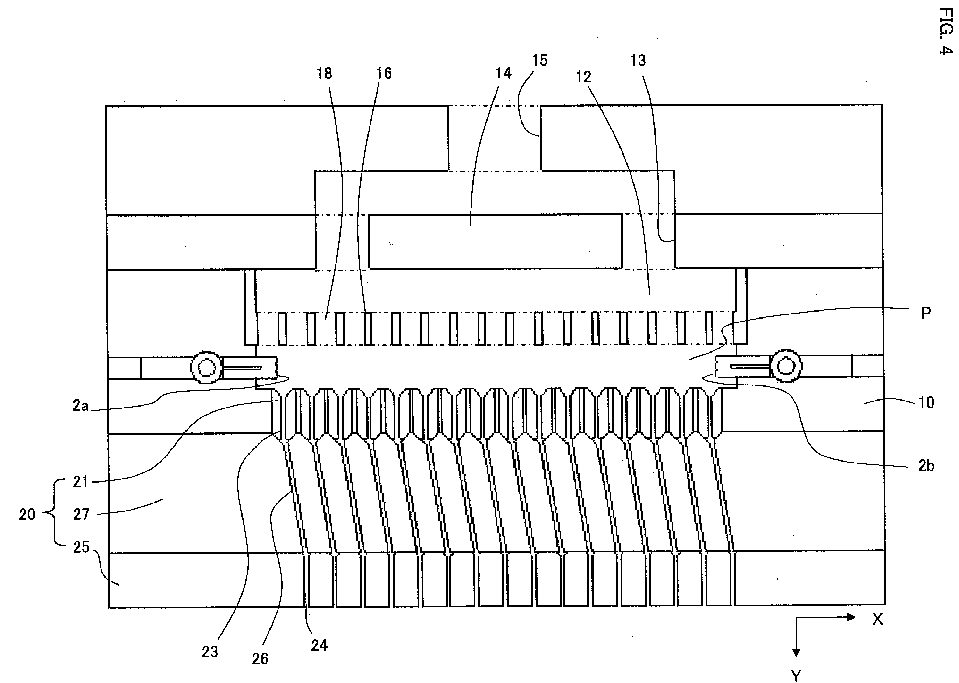

With reference to FIG. 4, a second embodiment of the apparatus of the present invention will next be described. In Embodiment 2, the second gas discharge section 22 of Embodiment 1 was changed to a second discharge section which consists of an oblique gas discharge section 27 including holes 26 that are oblique with respect to the y-axis, and an upright gas discharge section 25 that is disposed upright along the Y-axis. Other members were the same as those employed in Embodiment 1. The oblique gas discharge section 27 had an oblique angle (with respect to the Y-axis) of 10°. The oblique angle is preferably 3° to 30°, more preferably 5° to 20°. In other words, preferably, the lower opening of a hole 23 cannot be seen from the lower opening of a hole 24; i.e., the two openings are not on the same axis. The projection length of the oblique gas discharge section with respect to the Y-axis is 12 mm, and the upright gas discharge section 25 has a length of 4 mm. Through this configuration, electrons can be reliably absorbed by the walls of the holes in the gas discharge section 20, and only radicals can be emitted through the tips of the holes 24. When a treatment object was irradiated with plasma for hydrophlicization by means of the apparatus of Embodiment 2, the surface of the object exhibited a contact angle of 9.5°, which is slightly larger than that obtained by the apparatus of Embodiment 1. However, electric discharge to the treatment object was thoroughly prevented. By provision of the oblique gas discharge section 27, the plasma-generating zone P cannot be visually identified through the openings of the holes 24. Thus, UV rays generated in the plasma-generating zone P are intercepted by the walls of the holes 26, whereby the treatment object is not irradiated with UV rays. As a result, the treatment subject was prevented from damaging by UV rays.

In the aforementioned Embodiments, a plurality of said plasma generators may be provided along the longitudinal direction (x-axis direction) or in parallel to the x-axis, whereby an object having a wide area can be treated. When n units of plasma generators are provided along the x-axis direction, an object can be treated in a width of 4n cm (in the above Embodiments). In this case, through conveying the treatment object along the axis normal to the X-axis and Y-axis, a wider area of the object can be treated. When a plurality of plasma generators are provided in parallel to the x-axis, through conveying the treatment object along the axis normal to the X-axis and Y-axis, thorough plasma irradiation can be performed. The holes 23, 24, and 26 have a cross-section normal to the gas flow direction, which cross-section is a circle or an oval, or a rectangle or slit-like pattern having a longitudinal axis normal to the x-axis and y-axis (an axis normal to the sheet of each drawing) in FIG. 1 or 4.

In the above Embodiments, when the cross-section of the plasma-generating zone P normal to the x-axis is a rectangle, a side thereof preferably has a length of 2 mm to 5 mm, and the cross-section preferably has an area of $3 mm^2$ to $25 mm^2$.

Industrial Applicability

The apparatus of the present invention can allow an object to be irradiated with linear plasma for the surface treatment of the object.

Description of Reference Numerals

100: Plasma generator
10: Casing
12: Gas intake section
P: Plasma-generating zone
16: Guide portion
18: Diffusion section
23, 25, 26: hole
20: Diffusion section
21: First diffusion section
22: Second diffusion section
27: Oblique gas discharge section
24: Straight gas discharge section

**Claims**

1. An atmospheric plasma generator (100), comprising:

> a longitudinally extending casing (10) which is made of an insulator and which defines a columnar plasma-generating zone (P);
> a gas intake section (12) for supplying a plasma-generating gas to the plasma-generating zone (P) in a direction normal to the longitudinal direction (X) of the plasma-generating zone (P) so as to attain a uniform gas distribution, in the longitudinal direction (X), over the plasma-generating zone (P);
> a pair of electrodes (2a, 2b) disposed in the plasma-generating zone (P); and
> a gas discharge section (20) for discharging the plasma generated in the plasma-generating zone (P), which section (20) is connected to the plasma-generating zone (P), which section (20) is disposed along the longitudinal direction (X) of the plasma-generating zone (P), and which section (20) comprises a number of elongate holes (23, 24) that extend in the direction of the flow of the generated gas-form plasma,
> **characterized in that**
> said pair of electrodes (2a, 2b) is disposed with a spacing in the longitudinal direction (X) of the plasma-generating zone (P).

2. An atmospheric plasma generator (100) according to claim 1, wherein the gas intake section (12) has a diffusion section (18) for supplying the plasma-generating gas over the plasma-generating zone (P) uniformly in the longitudinal direction (X), the diffusion section (18) having a number of guide portions (16) for guiding the plasma-generating gas in a direction normal to the longitudinal direction (X) of the plasma-generating zone (P).

3. An atmospheric plasma generator (100) according to claim 1 or 2, wherein said holes (23, 24) of the gas discharge section (20) have such a length that no electric discharge occurs with respect to an object to be irradiated with plasma.

4. An atmospheric plasma generator (100) according to any one of claims 1 to 3, wherein said holes (23, 24) of the gas discharge section (20) have a tip having a diameter of 0.1 mm to 1 mm.

5. An atmospheric plasma generator (100) according to any one of claims 1 to 4, wherein said holes (23, 24) of the gas discharge section (20) have a length which is 1/2 times or more the distance between said pair of electrodes (2a, 2b).

6. An atmospheric plasma generator (100) according to any one of claims 1 to 5, wherein said holes (23, 24) of the gas discharge section (20) have an oblique portion (26) which is oblique with respect to a direction normal to the longitudinal direction (X).

7. An atmospheric plasma generator (100) according to any one of claims 1 to 6, wherein said pair of electrodes (2a, 2b) are disposed with a spacing of 1 cm to 50 cm.

8. An atmospheric plasma generator (100) according to any one of claims 1 to 7, wherein at least one electrode of said pair of electrodes (2a, 2b) is provided with hollow portions (H) on a surface thereof which face the other electrode.

9. An atmospheric plasma generator (100) according to any one of claims 1 to 8, wherein the longitudinal length L (cm) of the columnar plasma-generating zone (P) and the cross-sectional area $\sigma$ (mm$^2$) normal to the longitudinal direction (X) satisfy the following relationships:

$$2 \leq L\sigma \leq 200 \text{ and } 3 \leq \sigma \leq 25.$$

10. An atmospheric plasma generator (100) according to any one of claims 1 to 9, where-in said holes (23, 24) of the gas discharge section (20) has a cross-section normal to a direction of gas flow, the cross-section being at least one selected from a group consisting of a circle, an oval, and a rectangle or a slit-like pattern having a longer side normal to the line of arrangement of the holes (23, 24).

**Patentansprüche**

1. Atmosphärenplasmaerzeuger (100), mit

   einem longitudinal erstreckten Gehäuse (10), das aus einem Isolator hergestellt ist und das eine säulenförmige Plasmaerzeugungszone (P) definiert,
   einem Gaseinlassabschnitt (12) zur Zufuhr eines Plasmaerzeugungsgases in die Plasmaerzeugungszone (P) in einer Normalenrichtung zu der Longitudinalrichtung (X) der Plasmaerzeugungszone (P), um eine gleichmäßige Gasverteilung in der Longitudinalrichtung (X) über die Plasmaerzeugungszone (P) zu erzielen,
   einem Paar von Elektroden (2a, 2b), die in der Plasmaerzeugungszone (P) angeordnet sind, und
   einem Gasablassabschnitt (20) zum Ablassen des in der Plasmaerzeugungszone (P) erzeugten Plasmas, wobei der Abschnitt (20) mit der Plasmaerzeugungszone (P) verbunden ist, wobei der Abschnitt (20) entlang der Longitudinalrichtung (X) der Plasmaerzeugungszone (P) angeordnet ist, und wobei der Abschnitt (20) eine Anzahl von länglichen Löchern (23, 24) aufweist, die sich in der Richtung des Flusses des erzeugten gasförmigen Plasmas erstrecken, **dadurch gekennzeichnet, dass**
   das Paar von Elektroden (2a, 2b) mit einem Abstand in der Longitudinalrichtung (X) der Plasmaerzeugungszone (P) angeordnet ist.

2. Atmosphärenplasmaerzeuger (100) nach Anspruch 1, wobei
   der Gaseinlassabschnitt (12) einen Diffusionsabschnitt (18) zur Zufuhr des Plasmaerzeugungsgases über die Plasmaerzeugungszone (P) gleichmäßig in der Longitudinalrichtung (X) aufweist, wobei der Diffusionsabschnitt (18) eine Anzahl von Führabschnitten (16) zum Führen des Plasmaerzeugungsgases in einer Normalenrichtung zu der Longitudinalrichtung (X) der Plasmaerzeugungszone (P) aufweist.

3. Atmosphärenplasmaerzeuger (100) nach Anspruch 1 oder 2, wobei
   die Löcher (23, 24) des Gasablassabschnitts (20) eine solche Länge aufweisen, dass keine elektrische Entladung bezüglich eines mit Plasma zu bestrahlenden Objekts auftritt.

4. Atmosphärenplasmaerzeuger (100) nach einem der Ansprüche 1 bis 3, wobei
   die Löcher (23, 24) des Gasablassabschnitts (20) eine Spitze mit einem Durchmesser von 0,1 mm bis 1 mm aufweisen.

5. Atmosphärenplasmaerzeuger (100) nach einem der Ansprüche 1 bis 4, wobei
   die Löcher (23, 24) des Gasablassabschnitts (20) eine Länge aufweisen, die das 1/2-fache oder mehr des Abstands zwischen dem Paar von Elektroden (2a, 2b) beträgt.

6. Atmosphärenplasmaerzeuger (100) nach einem der Ansprüche 1 bis 5, wobei
   die Löcher (23, 24) des Gasablassabschnitts (20) einen schrägen Abschnitt (26) aufweisen, der schräg bezüglich einer Normalenrichtung zu der Longitudinalrichtung (X) ist.

7. Atmosphärenplasmaerzeuger (100) nach einem der Ansprüche 1 bis 6, wobei
   das Paar von Elektroden (2a, 2b) mit einem Abstand von 1 cm bis 50 cm angeordnet ist.

8. Atmosphärenplasmaerzeuger (100) nach einem der Ansprüche 1 bis 7, wobei
   zumindest eine Elektrode des Paars von Elektroden (2a, 2b) mit hohlen Abschnitten (H) an einer Oberfläche davon, die der anderen Elektrode gegenüber liegt, versehen ist.

9. Atmosphärenplasmaerzeuger (100) nach einem der Ansprüche 1 bis 8, wobei
   die Longitudinallänge L (cm) der säulenförmigen Plasmaerzeugungszone (P) und die Querschnittsfläche $\sigma$ (mm$^2$) normal zu der Longitudinalrichtung (X) die folgenden Beziehungen erfüllen:

$$2 \leq L\sigma \leq 200 \text{ und } 3 \leq \sigma \leq 25.$$

10. Atmosphärenplasmaerzeuger (100) nach einem der Ansprüche 1 bis 9, wobei
    die Löcher (23, 24) des Gasablassabschnitts (20) einen Querschnitt normal zu einer Richtung eines Gasflusses aufweisen, wobei der Querschnitt zumindest ein aus einer Gruppe bestehend aus einem Kreis, einem Oval, und einem Rechteck oder einem schlitzartigen Muster mit einer längeren Seite normal zu der Anordnungslinie der Löcher (23, 24) ausgewählter ist.

**Revendications**

1. Générateur de plasma atmosphérique (100), comprenant :

   un carter (10) s'étendant longitudinalement qui est composé d'un isolateur et qui définit une zone de génération de plasma en forme de colonne (P) ;

une section d'admission de gaz (12) destinée à amener un gaz de génération de plasma à la zone de génération de plasma (P) dans une direction perpendiculaire à la direction longitudinale (X) de la zone de génération de plasma (P) de manière à obtenir une distribution de gaz uniforme, dans la direction longitudinale (X), sur toute la zone de génération de plasma (P) ; une paire d'électrodes (2a, 2b) disposées dans la zone de génération de plasma (P) ; et une section de décharge de gaz (20) destinée à décharger le plasma généré dans la zone de génération de plasma (P), laquelle section (20) est raccordée à la zone de génération de plasma (P), laquelle section (20) est disposée le long de la direction longitudinale (X) de la zone de génération de plasma (P), et laquelle section (20) comprend un certain nombre de trous allongés (23, 24) qui s'étendent dans la direction de l'écoulement du plasma sous forme de gaz généré,

**caractérisé en ce que**

ladite paire d'électrodes (2a, 2b) sont espacées dans la direction longitudinale (X) de la zone de génération de plasma (P).

2. Générateur de plasma atmosphérique (100) selon la revendication 1, dans lequel la section d'admission de gaz (12) présente une section de diffusion (18) destinée à amener le gaz de génération de plasma sur toute la zone de génération de plasma (P) de manière uniforme dans la direction longitudinale (X), la section de diffusion (18) présentant un certain nombre de parties de guidage (16) destinées à guider le gaz de génération de plasma dans une direction perpendiculaire à la direction longitudinale (X) de la zone de génération de plasma (P).

3. Générateur de plasma atmosphérique (100) selon la revendication 1 ou 2, dans lequel lesdits trous (23, 24) de la section de décharge de gaz (20) présentent une longueur telle qu'aucune décharge électrique ne se produit par rapport à un objet à irradier au plasma.

4. Générateur de plasma atmosphérique (100) selon l'une quelconque des revendications 1 à 3, dans lequel lesdits trous (23, 24) de la section de décharge de gaz (20) présentent une pointe possédant un diamètre de 0,1 mm à 1 mm.

5. Générateur de plasma atmosphérique (100) selon l'une quelconque des revendications 1 à 4, dans lequel lesdits trous (23, 24) de la section de décharge de gaz (20) présentent une longueur qui atteint 1/2 fois ou plus la distance entre ladite paire d'électrodes (2a, 2b).

6. Générateur de plasma atmosphérique (100) selon l'une quelconque des revendications 1 à 5, dans lequel lesdits trous (23, 24) de la section de décharge de gaz (20) présentent une partie oblique (26) qui est oblique par rapport à une direction perpendiculaire à la direction longitudinale (X).

7. Générateur de plasma atmosphérique (100) selon l'une quelconque des revendications 1 à 6, dans lequel ladite paire d'électrodes (2a, 2b) sont espacées de 1 cm à 50 cm.

8. Générateur de plasma atmosphérique (100) selon l'une quelconque des revendications 1 à 7, dans lequel au moins une électrode de ladite paire d'électrodes (2a, 2b) est pourvue de parties creuses (H) sur sa surface, lesquelles sont tournées vers l'autre électrode.

9. Générateur de plasma atmosphérique (100) selon l'une quelconque des revendications 1 à 8, dans lequel la direction longitudinale L (cm) de la zone de génération de plasma (P) en forme de colonne et la superficie de section $\sigma$ (mm$^2$) perpendiculaire à la direction longitudinale (X) satisfont les relations suivantes :

$$2 \leq L\sigma \leq 200 \text{ et } 3 \leq \sigma \leq 25.$$

10. Générateur de plasma atmosphérique (100) selon l'une quelconque des revendications 1 à 9, dans lequel lesdits trous (23, 24) de la section de décharge de gaz (20) présentent une section transversale perpendiculaire à une direction d'écoulement de gaz, la section transversale étant au moins une sélectionnée parmi un groupe constitué d'un cercle, d'un ovale, et d'un rectangle ou d'un motif du type fente présentant un côté plus long perpendiculairement à la ligne d'agencement des trous (23, 24).

FIG. 1

FIG. 2

FIG. 3

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006196210 A
- JP 2006272039 A
- WO 2007142166 A2
- JP 2008010373 A